(19) Europäisches Patentamt European Patent Office Office européen des brevets

(11) **EP 4 765 603 A1**

(12) **DEMANDE DE BREVET EUROPEEN**

(43) Date de publication:
**24.06.2026  Bulletin 2026/26**

(21) Numéro de dépôt: **25224712.7**

(22) Date de dépôt: **17.12.2025**

(51) Classification Internationale des Brevets (IPC):
***H02M 1/00*** *(2006.01)*

(52) Classification Coopérative des Brevets (CPC):
**H02M 1/0003**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **19.12.2024  FR 2414776**

(71) Demandeur: **Commissariat à l'Energie Atomique et aux Energies Alternatives
75015 Paris (FR)**

(72) Inventeurs:
• **FASSI, Youssof
  38054 GRENOBLE Cedex 9 (FR)**
• **HEIRIES, Vincent
  38054 GRENOBLE Cedex 9 (FR)**
• **BOUTET, Jérôme
  38054 GRENOBLE Cedex 9 (FR)**
• **BOISSEAU, Sébastien
  38054 GRENOBLE Cedex 9 (FR)**

(74) Mandataire: **Germain Maureau
12, rue Boileau
69006 Lyon (FR)**

(54) **SYSTÈME ET PROCÉDÉ D'ESTIMATION D'UNE GRANDEUR CARACTÉRISTIQUE DU FONCTIONNEMENT D'UN CONVERTISSEUR DE PUISSANCE**

(57)    L'invention concerne un procédé d'estimation d'une grandeur caractéristique du fonctionnement d'un convertisseur de puissance candidat comprenant un transformateur (1c), le procédé étant exécuté par une unité de traitement de données (110) et comprenant les étapes suivantes : - acquisition d'un signal représentatif des vibrations émises par le transformateur (1c) ; - estimation de la grandeur caractéristique du fonctionnement du convertisseur de puissance candidat sur la base du signal représentatif des vibrations détectées.

[Fig.2]

EP 4 765 603 A1

## Description

La présente invention concerne le domaine du traitement des signaux et de l'optimisation des réseaux neuronaux, en particulier les méthodes et les systèmes de compression et d'analyse des données ultrasonores à haute dimension pour la prédiction d'une grandeur caractéristique du fonctionnement dans les applications industrielles.

## Etat de la technique

Pour suivre le fonctionnement d'un convertisseur, il convient de mesurer au moins une grandeur caractéristique du fonctionnement. A titre d'exemple de grandeur caractéristique de ce fonctionnement, le rendement d'un convertisseur est une grandeur bien connue qui se calcule comme le rapport entre la puissance de sortie et la puissance consommée en entrée.

La mesure du rendement des convertisseurs de puissance présente plusieurs défis. Les méthodes actuelles nécessitent généralement des capteurs pour mesurer les courants et les tensions d'entrée et de sortie, ce qui est invasif et implique une isolation galvanique appropriée à des valeurs de courant et des tension élevées et ajoute de l'encombrement au système. En outre, il peut être difficile de mesurer avec précision la puissance de sortie de systèmes complets, ce qui nécessite souvent des approximations des pertes à l'aide de simulations. Ces simulations peuvent manquer de précision en raison de la complexité des systèmes et de la variabilité des conditions opérationnelles. D'autres méthodes utilisent des mesures calorimétriques, mais elles ne sont utilisées que pour des estimations hors ligne.

La présente invention a pour objet de résoudre tout ou partie des inconvénients mentionnés ci-dessus.

## Exposé de l'invention

A cet effet, la présente invention concerne La présente invention concerne un procédé d'estimation d'une grandeur caractéristique du fonctionnement d'un convertisseur de puissance candidat comprenant un transformateur, le procédé étant exécuté par une unité de traitement de données et comprenant les étapes suivantes :

- acquisition d'un signal représentatif des vibrations émises par le transformateur ;
- estimation de la grandeur caractéristique du fonctionnement du convertisseur de puissance candidat sur la base du signal représentatif des vibrations détectées utilisant un traitement d'inférence d'une grandeur caractéristique du fonctionnement basé sur un modèle d'intelligence artificielle,

le procédé comprenant une phase d'apprentissage préalable du modèle d'intelligence artificielle pour l'estimation d'une grandeur caractéristique du fonctionnement d'un convertisseur de puissance candidat, comprenant les étapes suivantes :

- acquisition d'un signal représentatif des vibrations émises par le transformateur d'un convertisseur de référence,
- acquisition d'au moins un signal représentatif d'au moins une grandeur électrique caractéristique d'un convertisseur de référence,
- Détermination d'une valeur calculée de rendement du convertisseur de référence sur la base de l'au moins un signal représentatif d'au moins une grandeur électrique ;
- Estimation d'une valeur estimée d'une grandeur caractéristique du fonctionnement du convertisseur de référence sur la base du signal représentatif des vibrations émises par le transformateur de référence ;
- Calcul d'une première fonction d'évaluation prenant en compte la valeur calculée d'une grandeur caractéristique du fonctionnement du convertisseur de référence et la valeur estimée d'une grandeur caractéristique du fonctionnement ($\hat{\eta}$) du convertisseur de référence
- Ajustement de paramètres du modèle d'intelligence artificielle en utilisant la première fonction d'évaluation.

Grâce à ces dispositions, il est possible de réaliser une estimation d'une grandeur caractéristique du fonctionnement d'un convertisseur de puissance de façon non invasive, de façon adaptée aux convertisseurs comprenant un transformateur qui génère des vibrations. En particulier, ce système est adapté aux convertisseurs AC/DC avec un transformateur.

Cette approche permet de surmonter les limites des capteurs invasifs traditionnels et des approximations basées sur la simulation, offrant ainsi une solution précise et non invasive pour la mesure d'une grandeur caractéristique du fonctionnement.

Selon une possibilité, la première fonction d'évaluation est une fonction de perte

Selon un mode de mise en œuvre, le procédé d'estimation comprend, préalablement à l'estimation d'une grandeur caractéristique du fonctionnement, une étape de compression des données du signal représentatif des vibrations détectées.

L'exploitation de signaux vibratoires génère des grands volumes de données impliqués, qui posent des défis importants en matière de stockage et d'analyse. Les techniques de compression des données offrent des solutions prometteuses aux problèmes de gestion des données.

Selon un mode de mise en œuvre, le procédé d'estimation comprend en outre une étape de conversion analogique numérique du signal représentatif des vibrations en un signal numérique représentatif des vibrations détectées.

Selon un mode de mise en œuvre, l'étape de compression des données du signal représentatif des vibrations détectées est réalisée en utilisant un module d'extraction de caractéristiques.

Selon un mode de mise en œuvre, le module d'extraction de caractéristiques est un encodeur convolutif.

Les modèles d'apprentissage profond tels que les réseaux neuronaux convolutifs (CNN) sont utilisés pour un entraînement et une inférence plus rapides., Selon un mode de réalisation, des couches convolutives avec remplissage sont utilisées.

Les auto-encodeurs basés sur les CNN peuvent compresser efficacement des données de haute dimension tout en préservant les caractéristiques essentielles

Selon un mode de mise en œuvre, des couches de convolution avec des grandes marches sont utilisées.

Cette approche permet la compression de signaux haute fréquence de haute qualité. Cette approche préserve l'intégrité des caractéristiques importantes des données ultrasons, ce qui garantit un traitement précis et efficace.

Selon un mode de mise en œuvre, le modèle d'intelligence artificielle comprend un réseau neuronal comprenant des couches entièrement connectées.

Ainsi, l'architecture de réseau neuronal combine des auto encodeurs convolutifs avec des couches entièrement connectées pour compresser et analyser les données ultrasonores de manière multitâche.

Selon une autre possibilité, l'étape d'estimation d'une grandeur caractéristique du fonctionnement du convertisseur de puissance utilise une méthode d'analyse spectrale.

Selon un mode de mise en œuvre, l'étape d'estimation comprend les sous-étape suivantes :

- une première étape de transformation du signal représentatif des vibrations de façon à en obtenir une représentation fréquentielle,
- une deuxième étape détermination d'au moins un rapport entre l'énergie contenue dans au moins une bande de fréquence par rapport à l'énergie totale du signal selon la représentation fréquentielle,
- une troisième étape de comparaison des rapports à des valeurs de référence établies expérimentalement de façon à estimer la valeur de la grandeur caractéristique du fonctionnement d'un convertisseur associé aux rapports.

Selon un mode de réalisation, la transformation réalisée est une transformation de Fourier, notamment pour obtenir une densité spectrale de puissance. Cette représentation fréquentielle permet de mettre en évidence les caractéristiques spectrales liées à une pluralité de régimes de puissance et de valeurs de la grandeur caractéristique du fonctionnement d'un convertisseur.

En effet, chaque régime de puissance ou valeur de la grandeur caractéristique du fonctionnement d'un convertisseur induit une signature spectrale spécifique, se manifestant par une répartition particulière de l'énergie dans une pluralité de bandes de fréquences.

Les bandes sont choisies de manière à discriminer les valeurs de régimes de puissance considérés. En calculant le rapport de l'énergie contenue dans chacune de ces bandes par rapport à l'énergie totale du signal, il est possible de caractériser des régimes de puissance.

Selon un mode de mise en œuvre, le signal représentatif des vibrations est un signal ultrason.

Selon un mode de mise en œuvre, la sonde à ultrason est placée à une distance fixe du transformateur du convertisseur de puissance, où le noyau vibre en présence d'un champ magnétique et transmet par voie aérienne des données ultrasonores à la sonde.

Les sondes à ultrasons captent les ondes sonores à haute fréquence (ondes de compression) qui se propagent dans un milieu. Ces ondes sont ensuite traduites en signaux électriques par l'intermédiaire d'un transducteur et peuvent être traitées pour recueillir des informations sur la source émettrice ou les propriétés du milieu. Contrairement aux capteurs électriques, ces sondes peuvent être placées à distance, ce qui réduit le risque d'interférence et la nécessité d'une isolation poussée.

Selon un mode de mise en œuvre, le procédé d'estimation comprend une étape de conditionnement et/ou d'amplification du signal représentatif des vibrations détectées.

Selon un mode de mise en œuvre, l'amplificateur est un amplificateur analogique configuré pour fournir une version amplifiée du signal représentatif des vibrations détectées au convertisseur analogique numérique.

Selon un mode de mise en œuvre, l'étape de conversion analogique numérique réalise un échantillonnage avec une fréquence supérieure à 300 kHz, en particulier avec une fréquence supérieure à 400 kHz.

Grâce à ces dispositions, il est possible d'identifier avec précision des phénomènes dans une bande de fréquence comprise entre 80 et 130 kHz. Selon un mode de réalisation, une fréquence de moins de 600 kHz est choisie. A titre d'exemple, une fréquence de l'ordre de 100 kHz peut être choisie.

Selon un mode de mise en œuvre, le signal représentatif des vibrations détectée traité par l'étape d'estimation ou par l'étape de compression est configuré sous forme d'échantillons comprenant un ensemble de données correspondant à une durée de détection comprise entre 1 et 10 alternances d'une tension d'entrée ou d'un courant d'entrée du convertisseur de référence, en particulier entre 3 et 8 alternances.

Selon un mode de mise en œuvre, un échantillon correspond à une suite temporelle / trame du signal représentatif des vibrations détectées.

Selon un mode de mise en œuvre, la durée de détection est comprise entre 1 et 200 ms, en particulier entre 50 et 150 ms.

Selon un exemple de mise en œuvre, la durée de détection est de l'ordre de 100 ms.

Selon un exemple de mise en œuvre, la grandeur caractéristique du fonctionnement d'un convertisseur est un rendement du convertisseur.

Selon d'autres variantes, la grandeur caractéristique du fonctionnement d'un convertisseur peut être par exemple la puissance de sortie, l'état de santé ou le courant redressé passant dans le transformateur, au lieu, ou en plus du rendement.

Selon un exemple de mise en œuvre, la phase d'apprentissage comprend en outre l'étape suivantes :

- synchronisation du signal représentatif des vibrations détectées et du signal représentatif d'au moins une grandeur électrique.

Le procédé comprend ainsi un mécanisme pour aligner les mesures électriques et ultrasonores, garantissant ainsi une corrélation précise des données.

Selon un exemple de mise en œuvre, le procédé comprend en outre les étapes suivantes :

- Compression du signal représentatif des vibrations détectées en utilisant un module d'extraction de caractéristiques, l'étape de compression étant réalisée avant l'étape d'estimation de la valeur estimée d'une grandeur caractéristique du fonctionnement ($\hat{\eta}$) du convertisseur de référence afin de fournir une version du signal représentatif des vibrations détectées dans un espace latent ;
- Reconstitution d'un signal reconstitué représentatif des vibrations détectées à partir de la version du signal représentatif des vibrations détectées dans un espace latent ;
- Calcul d'une deuxième fonction d'évaluation prenant en compte le signal reconstitué représentatif des vibrations détectées, et la version du signal représentatif des vibrations détectées dans un espace latent ;
- Ajustement des paramètres du module d'extraction de caractéristiques en utilisant la deuxième fonction d'évaluation.

En intégrant des informations de l'espace latent, qui peut être considéré comme des informations sur le domaine des fréquences dans la fonction de perte, le système réduit considérablement les erreurs de reconstruction et améliore la précision de la prédiction d'une grandeur caractéristique du fonctionnement par rapport aux méthodes traditionnelles. Cette approche double garantit que la représentation comprimée est à la fois efficace et informative, ce qui permet d'obtenir de meilleures performances dans les applications en temps réel.

Selon un exemple de mise en œuvre, le procédé d'estimation comprend une étape d'ajustement des paramètres du module d'extraction de caractéristiques, et l'étape d'ajustement de paramètres du modèle d'intelligence artificielle sont réalisées de manière parallèle.

Selon un mode de mise en œuvre, l'étape de calcul d'une première fonction d'évaluation et l'étape d'ajustement de paramètres du modèle d'intelligence artificielle d'une part, l'étape de reconstitution d'un signal reconstitué représentatif des vibrations détectées, l'étape de calcul d'une deuxième fonction d'évaluation et l'étape d'ajustement des paramètres du module d'extraction de caractéristiques d'autre part sont réalisées de manière parallèle.

Selon un mode de mise en œuvre, le procédé d'estimation comprend les étapes d'un procédé d'apprentissage tel que défini précédemment.

L'invention concerne également un procédé de contrôle ou de commande d'un convertisseur de puissance comprenant les étapes d'un procédé d'estimation d'une grandeur caractéristique du fonctionnement d'un convertisseur candidat tel que défini précédemment, et comprenant les étapes suivantes :

- Détection d'une baisse de rendement du convertisseur candidat ;
- Emission d'une alerte à destination d'un utilisateur et/ou
- Enclenchement d'un mode de fonctionnement dégradé du convertisseur candidat ;

L'invention concerne également un système d'estimation d'une grandeur caractéristique du fonctionnement d'un convertisseur de puissance comprenant au moins un transformateur, le système comportant une unité de traitement comprenant :

- Un module d'acquisition comprenant un détecteur de vibration configuré pour détecter des vibrations émises par le transformateur et pour fournir un signal représentatif des vibrations détectées ;
- Un module d'estimation d'une grandeur caractéristique du fonctionnement ($\hat{\eta}$) du convertisseur de puissance sur la base du signal représentatif des vibrations détectées ;

L'unité de traitement étant configurée pour mettre en œuvre un procédé selon l'une des revendications 1 à 11

Selon un mode de réalisation, le détecteur de vibration est une sonde à ultrason.

Selon un mode de réalisation, la sonde à ultrason est placée à une distance fixe du transformateur du convertisseur de puissance, où le noyau vibre en présence d'un champ magnétique et transmet par voie aérienne des données ultrasonores à la sonde.

Selon une autre possibilité, le détecteur de vibration est un détecteur piézo-électrique.

Selon un mode de réalisation, le détecteur de vibration est disposé en regard du transformateur du convertisseur.

Selon un mode de réalisation, le module d'acquisition comprend une pluralité de détecteurs de vibration.

Selon un mode de réalisation, le système comprenant un convertisseur analogique numérique configuré pour convertir le signal représentatif des vibrations détectées en un signal numérique représentatif des vibrations détectées ;

La présente invention concerne également un produit programme d'ordinateur comprenant des instructions de code pour l'exécution d'un procédé défini précédemment, lorsque ledit programme est exécuté sur un ordinateur.

La présente invention concerne également un moyen de stockage lisible par un équipement informatique sur lequel est enregistré un produit programme d'ordinateur comprenant des instructions de code pour l'exécution d'un procédé tel que défini précédemment.

**Description brève des figures**

L'invention sera décrite en références aux figures suivantes qui sont données à titre indicatif et qui ne sont pas reproduites à l'échelle. Dans ces figures, les mêmes références désignent les mêmes éléments.

La [Figure 1] représente un système selon l'invention en configuration d'apprentissage ;
La [Figure 2] représente un système selon l'invention en configuration d'inférence ;
La [Figure 3] représente l'organigramme d'un procédé d'apprentissage selon un premier mode de réalisation de l'invention ;
La [Figure 4] représente l'organigramme d'un procédé d'estimation selon un premier mode de réalisation de l'invention ;

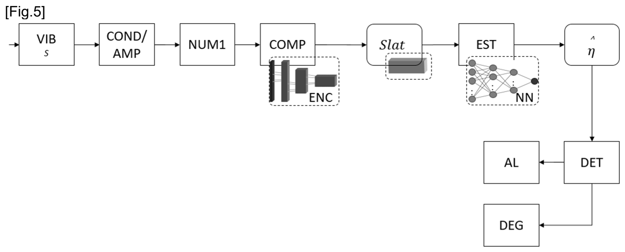

La [Figure 5] représente un procédé de contrôle ou de commande d'un convertisseur de puissance selon l'invention ;
La [Figure 6] représente l'organigramme d'un procédé d'apprentissage selon un deuxième mode de réalisation de l'invention ;

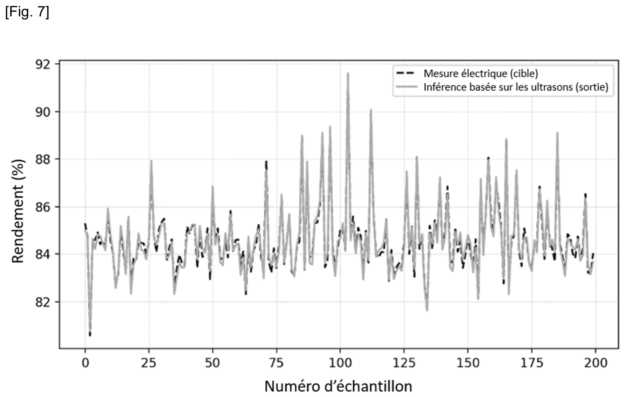

La [Figure 7] représente la comparaison entre les résultats d'estimation et des résultats de mesure.

**Description détaillée**

Un premier mode de réalisation de l'invention, mettant en œuvre un système et un procédé basé sur un apprentissage et traitement d'inférence d'une grandeur caractéristique du fonctionnement basé sur un modèle d'intelligence artificielle (NN) sera décrit dans un premier temps.

**Système en configuration d'apprentissage**

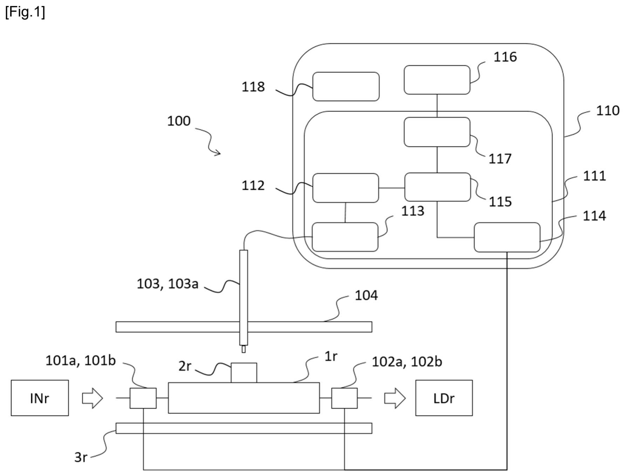

Selon un premier mode de réalisation, comme cela est représenté sur la figure 1 dans une configuration d'apprentissage, un système 100 d'estimation d'une grandeur caractéristique du fonctionnement d'un convertisseur est associé à un convertisseur de puissance de référence 1r. Ce convertisseur de puissance de référence 1r comprend, notamment dans le cas d'un convertisseur AC/DC, un ou plusieurs transformateurs 2r. Le convertisseur de puissance de référence 1r est lié à un premier support 3r. Le convertisseur assure la conversion entre une alimentation en puissance en entrée INr et une charge adaptative en sortie LDr.

Le système d'estimation 100 comprend, dans une configuration d'apprentissage, un capteur de courant d'entrée 101a et un capteur de tension d'entrée 101b du convertisseur de puissance de référence 1r disposés en entrée du convertisseur de puissance de référence, et un capteur de courant de sortie 102a et un capteur de tension de sortie 102b du convertisseur de puissance de référence 1r disposés en sortie du convertisseur de puissance de référence.

Le système d'estimation 100 comprend par ailleurs un détecteur de vibration 103. Dans l'exemple représenté sur la figure 1, le détecteur de vibration est une sonde à ultrason 103a, solidaire d'un deuxième support 104. En particulier, le deuxième support 104 est fixe par rapport au premier support 3. La sonde est disposée en regard du transformateur 2 à une distance fixe. Le transformateur 2r comprend un noyau qui vibre en présence d'un champ magnétique qui génère et transmet par voie aérienne un signal ultrasonore à la sonde.

Selon un exemple, la sonde à ultrasons positionnée à une distance fixe comprise entre 6 et 15 cm du convertisseur de puissance et au-dessus du transformateur, afin que la sonde capture des signaux acoustiques complets sans interférer avec le fonctionnement du système. Le positionnement précis de la sonde est obtenu grâce à un premier support 3 comprenant un système de montage calibré qui maintient une distance et un angle constants par rapport au convertisseur de puissance 1r.

Le système d'estimation 100 comprend une unité de traitement de données 110 qui comprend un module d'acquisition de données 111 configuré pour acquérir un signal représentatif des vibrations détectées par le détecteur 103 et un signal représentatif des grandeurs électriques de tension et de courant en entrée et en sortie.

En particulier, le module d'acquisition de données 111 comprend :

- un sous-module 112 d'acquisition d'un signal en provenance du détecteur de vibration 103, qui peut être associé à un conditionneur de signal de vibration 113 et en particulier un conditionneur de signal ultrason dans le cas où le détecteur de vibration est une sonde à ultrason 103a ; et

- un sous-module 114 d'acquisition de signaux représentatifs des grandeurs électriques de tension et de courant en entrée et en sortie provenant des capteurs 101a, 101b, 102a et 102b.

Le module d'acquisition 111 comprend également un convertisseur analogique numérique 115 configuré pour convertir le signal représentatif des vibrations détectées en un signal numérique représentatif des vibrations détectées, et de la même façon les signaux représentatifs des grandeurs électriques en des signaux numériques. Selon une possibilité, le convertisseur analogique numérique 115 peut comprendre deux convertisseurs qui sont compris respectivement dans les sous-modules 112 et 114.

L'unité de traitement de données 110 comprend également un module d'estimation d'une grandeur caractéristique du fonctionnement du convertisseur de puissance 116 qui collecte et traite les données fournies par le convertisseur analogique numérique 115.

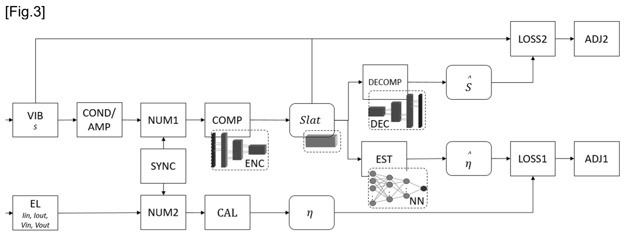

Le module d'estimation d'une grandeur caractéristique du fonctionnement met en œuvre, dans la configuration d'apprentissage, des étapes de procédé qui sont décrites ci-dessous en référence à la figure 3 sur la base des signaux représentatifs des vibrations et des signaux représentatifs des grandeurs électriques.

Le système comprend également un module de synchronisation 117 situé en aval du convertisseur analogique numérique 115 qui aligne le moment de la capture ou acquisition des signaux représentatifs de la vibration sur la capture ou acquisition des mesures électriques du convertisseur de puissance. Le réseau apprend alors efficacement la correspondance entre les signaux ultrasonores et le rendement du convertisseur de puissance, ce qui permet de déduire le rendement avec précision.

L'unité de traitement de données 110 comprend également une mémoire 118.

**Système en configuration d'inférence**

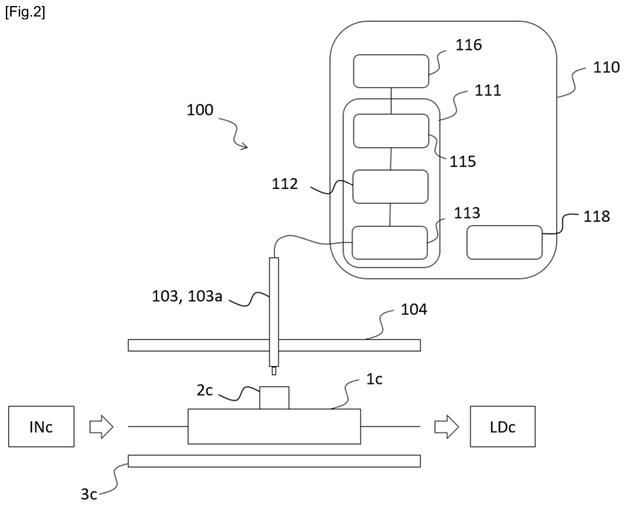

Comme cela est représenté sur la figure 2 dans une configuration d'inférence, un système 100 d'estimation d'une grandeur caractéristique du fonctionnement d'un convertisseur est associé à un convertisseur de puissance candidat 1c du même type que le convertisseur de référence 1r. Ce convertisseur de puissance candidat 1c comprend, notamment dans le cas d'un convertisseur AC/DC, un ou plusieurs transformateurs 2c. Le convertisseur de puissance de référence 1 est lié à un premier support 3c. Le convertisseur assure la conversion entre une alimentation en puissance en entrée INc et une charge en sortie LDc.

Le système d'estimation 100 comprend, comme dans la configuration d'apprentissage, un détecteur de vibration 103. Dans l'exemple représenté sur la figure 1, le détecteur de vibration est une sonde à ultrason 103a, solidaire d'un deuxième support 104. En particulier, le deuxième support 104 est fixe par rapport au premier support 3r. La sonde est disposée en regard du transformateur 2 à une distance fixe. Le transformateur 2r comprend un noyau qui vibre en présence d'un champ magnétique qui génère et transmet par voie aérienne un signal ultrasonore à la sonde.

Dans la configuration d'inférence, le système ne met pas en oeuvre de capteurs de grandeurs électriques, contrairement à la configuration d'apprentissage.

De façon similaire à la configuration d'apprentissage, selon un exemple, la sonde à ultrasons positionnée à une distance fixe comprise entre 6 et 15 cm du convertisseur de puissance et au-dessus du transformateur, afin que la sonde capture des signaux acoustiques complets sans interférer avec le fonctionnement du système. Le positionnement précis de la sonde est obtenu grâce à un premier support 3 comprenant un système de montage calibré qui maintient une distance et un angle constants par rapport au convertisseur de puissance.

Le système d'estimation 100 comprend également une unité de traitement de données 110 qui comprend un module d'acquisition de données 111 configuré pour acquérir un signal représentatif des vibrations détectées par le détecteur 103.

Contrairement à la configuration d'apprentissage, l'unité de traitement de données 110 n'a pas à traiter de signaux représentatifs des grandeurs électriques.

Ainsi, dans la configuration d'inférence, le module d'acquisition de données 111 comprend un sous-module 112 d'acquisition d'un signal en provenance du détecteur de vibration 103, qui peut être associé à un conditionneur de signal de vibration 113 et en particulier un conditionneur de signal ultrason dans le cas où le détecteur de vibration est une sonde à ultrason 103a.

Le module d'acquisition 111 comprend également un convertisseur analogique numérique 115 configuré pour convertir le signal représentatif des vibrations détectées en un signal numérique représentatif des vibrations détectées.

L'unité de traitement de données 110 comprend également un module d'estimation d'une grandeur caractéristique du fonctionnement - par exemple le rendement - du convertisseur de puissance 116 qui collecte et traite les données fournies par le convertisseur analogique numérique 115.

L'unité de traitement de données 110 comprend également une mémoire 118.

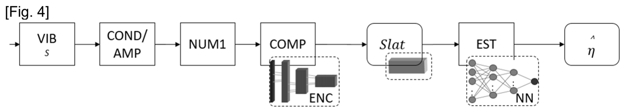

Le module d'estimation d'une grandeur caractéristique du fonctionnement met en œuvre, dans la configuration d'inférence, des étapes de procédé qui sont décrites ci-dessous en référence à la figure 4 sur la base des signaux représentatifs des vibrations mais sans avoir à traiter de données relatives aux signaux représentatifs des grandeurs électriques.

Dans la configuration d'inférence, le module de synchronisation n'est pas présent.

Ainsi, en mode d'inférence, le système d'estimation est plus simple que dans le mode d'apprentissage, et ne nécessite pas de capteur de mesure électrique invasif dans le convertisseur.

**Procédé d'apprentissage**

Comme cela est représenté sur la figure 3, le procédé d'apprentissage, exécuté par l'unité de traitement de données 100, comprend des étapes d'acquisition, et en particulier :

- une étape d'acquisition VIB d'un signal S représentatif des vibrations émises par le transformateur 2r du convertisseur de référence 1r ; et
- Une étape d'acquisition EL de signaux représentatifs de grandeurs électriques caractéristique d'un convertisseur de référence 1r.

Les signaux représentatifs des grandeurs électriques comprennent en particulier :

- Un signal de courant d'entrée Iin fourni par le capteur de courant d'entrée 101a ;
- Un signal de tension d'entrée Vin fourni par le capteur de tension d'entrée 101b ;
- Un signal de courant de sortie Iout fourni par le capteur de courant de sortie 102a ; et
- Un signal de tension de sortie Vout fourni par et le capteur de tension de sortie 102b.

Le procédé peut comprendre une étape COND/AMP de conditionnement et/ou d'amplification du signal S représentatif des vibrations réalisées par le conditionneur de signal de vibration 113. L'amplification est ainsi réalisée de façon analogique.

Le procédé comprend une étape de synchronisation SYNC du signal S représentatif des vibrations et des signaux représentatifs des grandeurs électriques Vin, Vout, Iin, Iout. Cette étape peut être réalisée par le module de synchronisation 115. L'étape de synchronisation permet d'aligner les mesures électriques et vibratoires, garantissant ainsi une corrélation précise des données.

Le procédé d'apprentissage comprend ensuite une étape NUM2 de conversion analogique numérique des signaux représentatifs des grandeurs électriques Vin, Vout, Iin, Iout, qui peut être réalisée par le sous-module 114 du convertisseur analogique numérique 111, puis une détermination par calcul CAL d'une valeur calculée de rendement du convertisseur η sur la base des signaux représentatifs des grandeurs électriques Vin, Vout, Iin, Iout. En particulier, Le rendement se calcule comme le rapport entre la puissance de sortie et la puissance consommée en entrée :

$$\eta = (Iout \times Vout) / (Iin \times Vin)$$

De façon parallèle, le procédé comprend des étapes de traitement du signal S représentative des vibrations.

En particulier, le procédé d'apprentissage comprend une étape de conversion analogique numérique NUM1 du signal S représentatif des vibrations en un signal numérique représentatif des vibrations détectées. Cette étape peut être réalisée par le sous-module 112 du convertisseur analogique numérique 111. Selon un exemple de réalisation, l'étape de conversion analogique numérique réalise un échantillonnage avec une fréquence supérieure à 300 kHz, en particulier avec une fréquence supérieure à 400 kHz. Selon un mode de réalisation, une fréquence de moins de 600 kHz est choisie. A titre d'exemple, une fréquence de l'ordre de 500 kHz peut être choisie. Il est ainsi possible d'identifier avec précision des phénomènes dans une bande de fréquence comprise entre 80 et 130 kHz.

Dans une étape de compression COMP, la version numérique du signal S peut ensuite être compressée par un auto encodeur de façon à fournir une version des données de vibration S transformée Slat dans un espace latent.

En particulier, selon un exemple de mise en œuvre, un auto encodeur convolutionnel est utilisé avec un pas allant de 2 à 8 et une taille de noyau allant de 3 à 11 pour compresser les données ultrasonores. L'auto encodeur réduit la dimensionnalité des données par un facteur allant de 8 à 128, tandis que le décodeur reconstruit un signal reconstitué Ŝ estimant signal original S.

Les échantillons traités du signal S correspondent à une suite temporelle ou trame du signal représentatif des vibrations détectées. En particulier, les échantillons comprennent un ensemble de données correspondant à une durée de détection comprise entre 1 et 10 alternances d'une tension d'entrée du convertisseur, en particulier entre 3 et 8 alternances. Selon des exemples de réalisation, la durée de détection est comprise entre 1 et 20 ms, en particulier entre 5 et 15 ms. En particulier, selon un exemple de réalisation, la durée de détection est de l'ordre de 10 ms.

Pour l'auto-encodeur, un réseau neuronal convolutif (CNN) est utilisé pour un entraînement et une inférence rapides. Des couches convolutives avec remplissage et grands pas sont utilisées pour la compression de signaux haute fréquence de haute qualité. Cette approche préserve l'intégrité des caractéristiques importantes des données vibratoires, ce qui garantit un traitement précis et efficace.

Le procédé comprend une étape d'estimation EST d'une valeur estimée d'une grandeur caractéristique du fonctionnement du convertisseur, par exemple le rendement, sur la base du signal S représentatif des vibrations émises par le transformateur 2c du convertisseur de référence 1c. L'estimation est réalisée en utilisant un réseau neuronal, en particulier un réseau neuronal comprenant des couches entièrement connectées.

Le procédé comprend ensuite une étape LOSS1 de calcul d'une première fonction de perte prenant en compte la valeur calculée $\eta$ du rendement du convertisseur de référence 1r et la valeur estimée du rendement $\hat{\eta}$ du convertisseur.

Par la suite, une première étape d'ajustement ADJ1 est réalisée, dans laquelle des paramètres du réseau neuronal NN sont ajustés sur la base du calcul de la première fonction de perte.

Le procédé comporte également une étape de décompression DECOMP des données de vibrations transformées Slat dans l'espace latent, de façon à reconstituer des données de vibrations $\hat{S}$.

Ensuite, une deuxième fonction de perte LOSS2 est calculée sur la base des données de vibration reconstituées, du signal des données de vibration S, mais aussi des données de vibration transformées dans l'espace latent.

Ainsi, dans une deuxième étape d'ajustement ADJ2, un ajustement des paramètres de l'encodeur/décodeur est réalisé.

En intégrant des informations sur le domaine des fréquences dans la fonction de perte, le système réduit considérablement les erreurs de reconstruction et améliore la précision de la prédiction du rendement par rapport aux méthodes traditionnelles. Cette approche double garantit que la représentation comprimée est à la fois efficace et informative, ce qui permet d'obtenir de meilleures performances dans les applications en temps réel.

Les étapes de décompression DECOMP, de calcul de la première fonction de perte LOSS1 et d'ajustement de l'encodeur ADJ1 d'une part et les étapes d'estimation EST, de calcul de la deuxième fonction de perte LOSS2 et d'ajustement du réseau neuronal ADJ2 d'autre part peuvent être réalisées de manière parallèle.

Le procédé d'apprentissage ainsi permet un traitement multitâche avec deux têtes : l'une pour la reconstruction du signal $\hat{S}$ et l'autre pour l'inférence du rendement. Cette conception garantit que la représentation comprimée Slat est optimisée pour les deux tâches.

Les étapes du procédé d'apprentissage peuvent être réalisées dans une pluralité de configurations de tension d'entrée/sortie, et d'intensité d'entrée/sortie avec un ou plusieurs convertisseurs présentant un état de fonctionnement nominal ou dégradé, afin de permettre un apprentissage efficace. A titre d'exemple, l'apprentissage peut être fait avec un seul convertisseur et en appliquant une charge variant entre 80% et 120% de la charge nominale du convertisseur permettant d'avoir la puissance nominale.

L'apprentissage réalisé avec un type de convertisseur peut potentiellement être valable pour d'autres types de convertisseurs, en utilisant des techniques de « transfer learning ».

**Procédé d'estimation et de contrôle/commande**

Une fois le procédé d'apprentissage réalisé, selon un mode de mise en oeuvre présenté sur la figure 4, un procédé d'estimation d'une grandeur caractéristique du fonctionnement, en particulier du rendement, d'un convertisseur de puissance candidat 1c exécuté par l'unité de traitement de données 110 comprend en premier lieu une étape d'acquisition VIB d'un signal S représentatif des vibrations émises par un transformateur 2c du convertisseur candidat 1c.

Une étape COND/AMP de conditionnement et/ou d'amplification du signal représentatif des vibrations détectées peut ensuite être réalisée.

Par la suite, une étape NUM1 de conversion analogique numérique du signal S représentatif des vibrations en un signal numérique représentatif des vibrations détectées est effectuée. L'amplification est réalisée de façon analogique par le module de conditionnement 113 pour fournir une version amplifiée du signal représentatif des vibrations détectées à l'étape de conversion analogique numérique NUM1.

Cette étape peut être réalisée par le sous-module 112 du convertisseur analogique numérique 111. Comme indiqué précédemment pour le procédé d'apprentissage, selon un exemple de réalisation, l'étape de conversion analogique numérique réalise un échantillonnage avec une fréquence supérieure à 300 kHz, en particulier avec une fréquence supérieure à 400 kHz. Selon un mode de réalisation, une fréquence de moins de 600 kHz est choisie. A titre d'exemple, une fréquence de l'ordre de 500 kHz peut être choisie. Il est ainsi possible d'identifier avec précision des phénomènes dans une bande de fréquence comprise entre 80 et 130 kHz.

Dans une étape de compression COMP, la version numérique du signal S peut ensuite être compressée par un auto encodeur de façon à fournir une version des données du signal représentatif des vibrations détectée S transformée Slat dans un espace latent.

En particulier, selon un exemple de mise en œuvre et de façon similaire au procédé d'apprentissage, un auto-encodeur convolutionnel est utilisé avec un pas allant de 2 à 8 et une taille de noyau allant de 3 à 11 pour compresser les données ultrasonores. L'auto-encodeur réduit la dimensionnalité des données par un facteur allant de 8 à 128.

Comme évoqué pour le procédé d'apprentissage, les échantillons traités du signal S correspondent à une suite temporelle ou trame du signal représentatif des vibrations détectées. En particulier, les échantillons comprennent un ensemble de données correspondant à une durée de détection comprise entre 1 et 10 alternances d'une tension d'entrée du convertisseur, en particulier entre 3 et 8 alternances. Selon des exemples de réalisation., la durée de détection est comprise entre 1 et 20 ms, en particulier entre 5 et 15 ms. En particulier, selon un exemple de réalisation, la durée de détection est de l'ordre de 10 ms.

L'auto-encodeur qui a fait l'objet du procédé d'apprentissage comprenant un réseau neuronal convolutif (CNN) est utilisé pour la compression. Des couches convolutives avec remplissage et grands pas sont utilisées pour la compression de signaux haute fréquence de haute qualité.

Une étape d'estimation EST d'une valeur estimée d'une grandeur caractéristique du fonctionnement $\hat{\eta}$ du convertisseur 1c est réalisée sur la base du signal S représentatif des vibrations émises par le transformateur 2c du convertisseur candidat 1c. L'estimation est réalisée en utilisant le réseau neuronal entrainé lors du procédé d'apprentissage, en particulier un réseau neuronal comprenant des couches entièrement connectées.

Grâce à ces dispositions, il est possible de réaliser une estimation d'une grandeur caractéristique du fonctionnement d'un convertisseur de puissance de façon non invasive, de façon adaptée aux convertisseurs comprenant un transformateur qui génère des vibrations. En particulier, ce système est adapté aux convertisseurs AC/DC avec un transformateur.

Cette approche permet de surmonter les limites des capteurs invasifs traditionnels et des approximations basées sur la simulation, offrant ainsi une solution précise et non invasive pour la mesure d'une grandeur caractéristique du fonctionnement.

Le procédé vise à estimer le rendement des convertisseurs de puissance. Il combine une sonde à ultrasons non invasive et un traitement d'inférence d'une grandeur caractéristique du fonctionnement basé sur un réseau neuronal. La sonde à ultrasons est placée à une distance fixe du transformateur des convertisseurs de puissance, où le noyau vibre en présence d'un champ magnétique et transmet par voie aérienne des données ultrasonores à une sonde. Le système intègre également des mécanismes de synchronisation pour aligner les mesures électriques et ultrasonores, garantissant ainsi une corrélation précise des données. Cette approche permet de surmonter les limites des capteurs invasifs traditionnels et des approximations basées sur la simulation, offrant ainsi une solution précise et non invasive pour la mesure d'une grandeur caractéristique du fonctionnement.

Le procédé introduit également une architecture de réseau neuronal qui combine des auto encodeurs convolutifs avec des couches entièrement connectées pour compresser et analyser les données ultrasonores de manière multitâche. En intégrant des informations sur le domaine des fréquences dans la fonction de perte, le système réduit considérablement les erreurs de reconstruction et améliore la précision de la prédiction d'une grandeur caractéristique du fonctionnement par rapport aux méthodes traditionnelles. Cette approche double garantit que la représentation comprimée est à la fois efficace et informative, ce qui permet d'obtenir de meilleures performances dans les applications en temps réel.

Selon une possibilité, un procédé de commande ou de contrôle d'un convertisseur de puissance, comprend les étapes décrites ci-dessus pour le procédé pour obtenir une estimation d'une grandeur caractéristique du fonctionnement $\hat{\eta}$ du convertisseur candidat 1c, et une étape de détermination DET d'une baisse de rendement du convertisseur ; en particulier, la valeur de rendement peut être comparée à une valeur de seuil ou un critère prenant en compte un dépassement de seuil sur une période de temps déterminée.

Suite à l'étape de détermination, une étape d'émission AL d'une alerte à destination d'un utilisateur peut être réalisée. Alternativement ou de manière complémentaire, une étape d'enclenchement d'un mode de fonctionnement dégradé DEG du convertisseur peut être réalisée.

### Résultats

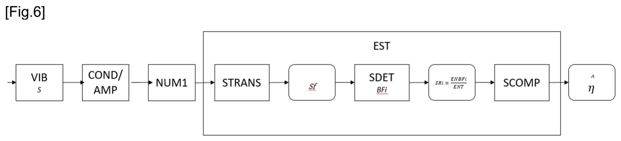

Comme cela est illustré sur la figure 6, Le système et le procédé d'estimation prédisent avec précision les valeurs de rendement, dans différentes conditions de charge (de 80 % à 120 % de la charge nominale) d'un convertisseur avec un pourcentage d'erreur moyen de 2,5 %.

### Variantes

Les variantes du système peuvent inclure différents types de sondes à ultrasons, tels que les capteurs MEMS CMUT et PMUT, avec des largeurs de bande variables pour capturer les différentes conditions de charge du fonctionnement du convertisseur de puissance. Une autre approche pourrait consister à utiliser plusieurs sondes à ultrasons positionnées autour du convertisseur de puissance pour localiser les sources d'ultrasons en formant un faisceau ou en utilisant des capteurs dans une configuration de réseau phasé, ce qui améliorerait encore la précision des prévisions de rendement et contribuerait aux travaux sur la maintenance prédictive pour la localisation des pannes.

Selon une autre variante non représentée, le détecteur de vibration peut être un détecteur piézo-électrique.

En ce qui concerne les variantes du procédé, les variantes peuvent inclure l'utilisation d'un pas plus petit avec des couches supplémentaires pour obtenir une compression similaire, ce qui permet un contrôle plus précis du taux de compression et une précision de reconstruction potentiellement plus élevée. Une autre solution pourrait consister à intégrer un autre type de réseau neuronal, tel qu'un réseau neuronal récurrent (RNN), pour le traitement séquentiel des données. Cette approche permet de mieux gérer les dépendances temporelles dans les données ultrasons, ce qui peut améliorer la précision de la prédiction. En outre, la mise en oeuvre d'une fonction de perte hybride qui combine les informations du domaine temporel et du domaine fréquentiel pourrait réduire davantage les erreurs de reconstruction et améliorer la qualité de la représentation comprimée. L'intégration de mécanismes d'attention dans l'espace latent peut également être envisagée pour mieux capturer les dépendances et les facteurs de pondération, améliorant ainsi la capacité du modèle à se concentrer sur les caractéristiques les plus pertinentes des données échographiques.

Dans le cadre de l'utilisation d'un réseau convolutif pour l'auto-encodeur, une autre approche utilisant des couches de mises en commun pourrait être utilisée. Les couches de mise en commun sont mieux adaptées aux tâches de classification, car elles réduisent la dimensionnalité en prenant la valeur maximale ou moyenne au sein d'un noyau, ce qui peut toutefois entraîner l'élimination de points de données pertinents.

Selon d'autres variantes, la grandeur caractéristique du fonctionnement d'un convertisseur peut être par exemple la puissance de sortie, l'état de santé ou le courant redressé passant dans le transformateur, au lieu, ou en plus du rendement.

**Procédé d'estimation d'une grandeur caractéristique du fonctionnement d'un convertisseur par analyse spectrale**

Un second mode de réalisation de l'invention est à présent décrit dans lequel une méthode d'analyse spectrale est utilisée.

Le système utilisé est similaire à celui utilisé pour le premier mode de réalisation en configuration d'inférence. Seul le procédé mis en œuvre par le module d'estimation 116 diffère. Le procédé est représenté sur la figure 6.

Dans le cas de l'utilisation d'une méthode spectrale, l'étape d'estimation EST du procédé comprend les sous-étapes suivantes.

La première étape est une étape STRANS de transformation du signal S représentatif des vibrations de façon à en obtenir une représentation fréquentielle Sf, par exemple une transformation de Fourier, notamment pour obtenir une densité spectrale de puissance DSP. La représentation fréquentielle permet de mettre en évidence les caractéristiques spectrales liées à une pluralité de régimes de puissance et à une pluralité de valeurs de la grandeur caractéristique du fonctionnement d'un convertisseur.

En effet, chaque régime de puissance ou valeur de la grandeur caractéristique du fonctionnement d'un convertisseur induit une signature spectrale spécifique, se manifestant par une répartition particulière de l'énergie dans une pluralité de bandes de fréquences BFi.

La deuxième étape est une étape de détermination SDET de rapports SRi de l'énergie ENBFi contenue dans chacune des bandes de fréquence BFi par rapport à l'énergie ENT totale du signal Sf.

Les bandes BFi sont choisies de manière à discriminer les valeurs de régimes de puissance considérés. En calculant le rapport SRi de l'énergie contenue dans chacune de ces bandes par rapport à l'énergie totale du signal, il est possible de caractériser des régimes de puissance.

Une troisième étape est une étape de comparaison SCOMP des rapports SRi à des valeurs de référence établies expérimentalement. Cette comparaison permet d'estimer la valeur de la grandeur caractéristique du fonctionnement d'un convertisseur associé aux rapports SRi. Les rapports SRi correspondent à des régimes de puissance.

La détermination des valeurs de référence peut être réalisée en utilisant un système tel que décrit en référence au premier mode de réalisation pour la configuration d'apprentissage. Seul le procédé mis en oeuvre par le module d'estimation 116 diffère. Dans le cas présent, des valeurs de références sont stockées en lien avec des valeurs des rapports Sri.

A titre d'exemple, quatre bandes de fréquence peuvent être définies autours des fréquences centrales suivantes : 116, 120, 123 et 130 kHz.

La grandeur caractéristique du fonctionnement d'un convertisseur peut être un rendement $\hat{\eta}$ du convertisseur, la puissance de sortie, l'état de santé ou le courant redressé passant dans le transformateur.

**Produit programme d'ordinateur**

L'invention concerne également un produit programme d'ordinateur comprenant des instructions de code pour l'exécution (sur les moyens de traitement de données 110 du système 1) d'un procédé d'apprentissage, d'estimation selon le premier ou le deuxième mode de réalisation et/ou de contrôle ou de commande ; ainsi que des moyens de stockage lisibles par un équipement informatique (par exemple les moyens de stockage de données ou mémoire 118 du système 1) sur lequel on trouve ce produit programme d'ordinateur.

**Applications**

Le procédé et le système décrit sont particulièrement destinés à la surveillance et au diagnostic en temps réel des convertisseurs de puissance dans diverses applications, notamment les systèmes d'énergie renouvelable, les alimentations industrielles et les véhicules électriques. Il fournit des mesures précises et non invasives d'une grandeur caractéristique du fonctionnement qui alimentent la surveillance de l'état et le diagnostic des convertisseurs de puissance.

Le procédé et le système décrits peuvent contribuer à optimiser à la conception des convertisseurs de puissance en augmentant la densité de puissance des nouveaux convertisseurs de puissance, grâce à la réduction de la nécessité de composants de surveillance encombrants. Le procédé et le système décrits peuvent également contribuer à optimiser le fonctionnement des convertisseurs grâce à la surveillance en temps réel de leur performance et de leur fiabilité, ce qui conduit à des améliorations d'une grandeur caractéristique du fonctionnement énergétique et de la longévité du convertisseur.

## Revendications

**1.** Procédé d'estimation d'une grandeur caractéristique du fonctionnement d'un convertisseur de puissance candidat (1c) comprenant un transformateur (1c), le procédé étant exécuté par une unité de traitement de données (110) et comprenant les étapes suivantes :

- acquisition (VIB) d'un signal représentatif (S) des vibrations émises par le transformateur (1c) ;
- estimation (EST) de la grandeur caractéristique du fonctionnement du convertisseur de puissance candidat (1c) sur la base du signal représentatif des vibrations détectées (S, Slat) utilisant un traitement d'inférence d'une grandeur caractéristique du fonctionnement basé sur un modèle d'intelligence artificielle (NN),

le procédé comprenant une phase d'apprentissage préalable du modèle d'intelligence artificielle (NN) pour l'estimation d'une grandeur caractéristique du fonctionnement d'un convertisseur de puissance candidat (1c), comprenant les étapes suivantes :

- acquisition (VIB) d'un signal représentatif (S) des vibrations émises par le transformateur d'un convertisseur de référence (1r),
- acquisition (EL) d'au moins un signal représentatif d'au moins une grandeur électrique caractéristique (Vin, Vout, Iin, Iout) d'un convertisseur de référence (1r),
- Détermination (CAL) d'une valeur calculée d'une grandeur caractéristique du fonctionnement ($\eta$) du convertisseur de référence (1r) sur la base de l'au moins un signal représentatif d'au moins une grandeur électrique (Vin, Vout, Iin, Iout) ;
- Estimation (EST) d'une valeur estimée ($\hat{\eta}$) d'une grandeur caractéristique du fonctionnement du convertisseur de référence ($\eta$) sur la base du signal représentatif des vibrations (S) émises par le transformateur de référence (1r) ;
- Calcul (LOSS1) d'une première fonction d'évaluation prenant en compte la valeur calculée ($\eta$) d'une grandeur caractéristique du fonctionnement du convertisseur de référence (1c) et la valeur estimée d'une grandeur caractéristique du fonctionnement ($\hat{\eta}$) du convertisseur de référence (1r)
- Ajustement (ADJ1) de paramètres du modèle d'intelligence artificielle (NN) en utilisant la première fonction d'évaluation (LOSS1).

**2.** Procédé d'estimation d'une grandeur caractéristique du fonctionnement d'un convertisseur de puissance candidat (1c) selon l'une des revendications précédentes, comprenant préalablement à l'estimation (EST) d'une grandeur caractéristique du fonctionnement, une étape de compression (COMP) des données du signal représentatif des vibrations détectées (S).

**3.** Procédé d'estimation d'une grandeur caractéristique du fonctionnement d'un convertisseur de puissance candidat (1c) selon l'une des revendications précédentes, comprenant en outre une étape de conversion analogique numérique (NUM1) du signal représentatif des vibrations (S) en un signal numérique représentatif des vibrations détectées (S).

**4.** Procédé d'estimation d'une grandeur caractéristique du fonctionnement d'un convertisseur de puissance candidat (1c) selon la revendication 2 ou selon la revendication 3 pour autant qu'elle dépende de la revendication 2, dans lequel l'étape de compression (COMP) des données du signal représentatif des vibrations détectées (S) est réalisée en utilisant un module d'extraction de caractéristiques (ENC).

**5.** Procédé d'estimation d'une grandeur caractéristique du fonctionnement d'un convertisseur de puissance candidat (1c) selon la revendication 4, dans lequel le module d'extraction de caractéristiques est un encodeur convolutif (ENC).

**6.** Procédé d'estimation d'une grandeur caractéristique du fonctionnement d'un convertisseur de puissance candidat (1c) selon l'une des revendications précédentes, dans lequel le signal représentatif des vibrations (S) est un signal ultrason.

**7.** Procédé d'estimation d'une grandeur caractéristique du fonctionnement d'un convertisseur de puissance candidat (1c) selon l'une des revendications précédentes, comprenant une étape de conditionnement et/ou d'amplification (COND/AMP) du signal représentatif (S) des vibrations détectées.

**8.** Procédé d'estimation d'une grandeur caractéristique du fonctionnement d'un convertisseur de puissance candidat (1c) selon l'une des revendications précédentes, dans lequel la grandeur caractéristique du fonctionnement d'un convertisseur est un rendement ($\hat{\eta}$) du convertisseur.

**9.** Procédé selon l'une quelconque des revendications précédentes, dans lequel la phase d'apprentissage comprend en outre l'étape suivantes :

- synchronisation (SYNC) du signal représentatif des vibrations détectées (S) et du signal représentatif d'au moins une grandeur électrique (Vin, Vout, Iin, Iout).

10. Procédé selon l'une quelconque des revendications précédentes, comprenant en outre les étapes suivantes :

- Compression (COMP) du signal représentatif des vibrations détectées (S) en utilisant un module d'extraction de caractéristiques (ENC), l'étape de compression (COMP) étant réalisée avant l'étape d'estimation (EST) de la valeur estimée d'une grandeur caractéristique du fonctionnement $(\hat{\eta})$ du convertisseur de référence (1r) afin de fournir une version (Slat) du signal représentatif des vibrations détectées (S) dans un espace latent ;
- Reconstitution (DECOMP) d'un signal reconstitué $(\hat{S})$ représentatif des vibrations détectées (S) à partir de la version (Slat) du signal représentatif des vibrations détectées (S) dans un espace latent ;
- Calcul (LOSS2) d'une deuxième fonction d'évaluation prenant en compte le signal reconstitué $(\hat{S})$ représentatif des vibrations détectées (S), et la version (Slat) du signal représentatif des vibrations détectées (S) dans un espace latent ;
- Ajustement (ADJ2) des paramètres du module d'extraction de caractéristiques (ENC) en utilisant la deuxième fonction d'évaluation (LOSS2).

11. Procédé selon la revendication 10, dans lequel l'étape d'ajustement (ADJ2) des paramètres du module d'extraction de caractéristiques (ENC), et l'étape d'ajustement (ADJ1) de paramètres du modèle d'intelligence artificielle (NN) sont réalisées de manière parallèle.

12. Système d'estimation d'une grandeur caractéristique du fonctionnement d'un convertisseur de puissance comprenant au moins un transformateur, le système comportant une unité de traitement (110) comprenant :

- Un module d'acquisition (111) comprenant un détecteur de vibration (103) configuré pour détecter des vibrations émises par le transformateur (1r, 1c) et pour fournir un signal représentatif des vibrations détectées (S) ;
- Un module d'estimation (116) d'une grandeur caractéristique du fonctionnement $(\hat{\eta})$ du convertisseur de puissance (1r, 1c) sur la base du signal représentatif des vibrations détectées (S),

l'unité de traitement de données (110) étant configurée pour mettre en oeuvre un procédé selon l'une des revendications 1 à 11.

13. Système selon la revendication 12, dans lequel le détecteur de vibration (103) est une sonde à ultrason.

14. Système selon l'une des revendications 12 à 13, dans lequel le détecteur de vibration (103) est disposé en regard du transformateur du convertisseur.

15. Système selon l'une des revendications 12 à 14, comprenant un convertisseur analogique numérique (115) configuré pour convertir le signal représentatif des vibrations détectées (S) en un signal numérique représentatif des vibrations détectées ;

16. Produit programme d'ordinateur comprenant des instructions de code pour l'exécution d'un procédé selon l'une des revendications 1 à 11, lorsque ledit programme est exécuté sur un ordinateur.

17. Moyen de stockage lisible par un équipement informatique sur lequel est enregistré un produit programme d'ordinateur comprenant des instructions de code pour l'exécution d'un procédé selon l'une des revendications 1 à 11.

[Fig.1]

[Fig.2]

[Fig.3]

[Fig. 4]

[Fig.5]

[Fig.6]

[Fig. 7]

Europäisches
Patentamt

European
Patent Office

Office européen
des brevets

## RAPPORT DE RECHERCHE EUROPEENNE

Numéro de la demande

EP 25 22 4712

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 111 555 169 A (GUILIN JUNTAIFU ELECTRIC CO LTD) 18 août 2020 (2020-08-18) * abrégé * * alinéa [0001] - alinéa [0078]; figures 1-9 * | 1-17 | INV. H02M1/00 |
| A | FASSI YOUSSOF ET AL: "Toward Physics-Informed Machine-Learning-Based Predictive Maintenance for Power Converters-A Review", IEEE TRANSACTIONS ON POWER ELECTRONICS, vol. 39, no. 2, 30 octobre 2023 (2023-10-30), pages 2692-2720, XP093330469, USA ISSN: 0885-8993, DOI: 10.1109/TPEL.2023.3328438 * abrégé * * sections I-VI * | 1-17 | |
| A | LUKAS CAVIGELLI ET AL: "CAS-CNN: A Deep Convolutional Neural Network for Image Compression Artifact Suppression", ARXIV.ORG, CORNELL UNIVERSITY LIBRARY, 201 OLIN LIBRARY CORNELL UNIVERSITY ITHACA, NY 14853, 22 novembre 2016 (2016-11-22), XP081361741, DOI: 10.1109/IJCNN.2017.7965927 * abrégé * * sections I-V * | 1-17 | **DOMAINES TECHNIQUES RECHERCHES (IPC)** H02M |

-----

-----

-/--

Le présent rapport a été établi pour toutes les revendications

| Lieu de la recherche | Date d'achèvement de la recherche | Examinateur |
|---|---|---|
| La Haye | 19 mars 2026 | Adami, Salah-Eddine |

EPO FORM 1503 03.82 (P04C02)

page 1 de 2

**EP 4 765 603 A1**

Europäisches Patentamt
European Patent Office
Office européen des brevets

## RAPPORT DE RECHERCHE EUROPEENNE

Numéro de la demande

EP 25 22 4712

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | REN LEI ET AL: "A Lightweight and Adaptive Knowledge Distillation Framework for Remaining Useful Life Prediction", IEEE TRANSACTIONS ON INDUSTRIAL INFORMATICS, IEEE SERVICE CENTER, NEW YORK, NY, US, vol. 19, no. 8, 25 novembre 2022 (2022-11-25), pages 9060-9070, XP011944782, ISSN: 1551-3203, DOI: 10.1109/TII.2022.3224969 [extrait le 2022-11-28] * abrégé * * sections 1-6 * | 1-17 | |
| A | SHAO HAIDONG ET AL: "A novel deep autoencoder feature learning method for rotating machinery fault diagnosis", MECHANICAL SYSTEMS AND SIGNAL PROCESSING, ELSEVIER, AMSTERDAM, NL, vol. 95, 1 avril 2017 (2017-04-01), pages 187-204, XP029994992, ISSN: 0888-3270, DOI: 10.1016/J.YMSSP.2017.03.034 * abrégé * * sections I-V * | 1-17 | |
| A | SHAOJIE BAI ET AL: "An Empirical Evaluation of Generic Convolutional and Recurrent Networks for Sequence Modeling", ARXIV.ORG, CORNELL UNIVERSITY LIBRARY, 201 OLIN LIBRARY CORNELL UNIVERSITY ITHACA, NY 14853, 4 mars 2018 (2018-03-04), XP081228078, * abrégé * * sections 1-6 * | 1-17 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| La Haye | 19 mars 2026 | Adami, Salah-Eddine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................................
& : membre de la même famille, document correspondant

EPO FORM 1503 03.82 (P04C02)

page 2 de 2

# EP 4 765 603 A1

## ANNEXE AU RAPPORT DE RECHERCHE EUROPEENNE
## RELATIF A LA DEMANDE DE BREVET EUROPEEN NO.

EP 25 22 4712

19-03-2026

| Document brevet cité au rapport de recherche | Date de publication | Membre(s) de la famille de brevet(s) | Date de publication |
|---|---|---|---|
| CN 111555169 A | 18-08-2020 | AUCUN | |

EPO FORM P0460